# DEMANDE DE BREVET EUROPEEN

(11) **EP 1 324 376 A1**
(43) Date de publication de la demande: **02.07.2003**
(21) Numéro de dépôt: 02356255.6
(22) Date de dépôt: 10.12.2002
(51) Int. Cl.: H01L 21/02

(54) **Composant electronique incorporant un circuit integre et un micro-condensateur planaire**

(30) Priorité: 31.12.2001 FR 0117069
(71) Demandeur: Memscap, 38190 Bernin (FR)
(72) Inventeur: Girardie, Lionel, 38320 Eybens (FR)
(74) Mandataire: Palix, Stéphane

(57) **Abrégé**

Composant électronique incorporant un circuit intégré réalisé dans un substrat (1) et un condensateur planaire, caractérisé en ce que le condensateur est réalisé au-dessus d'un niveau de métallisation du composant, ce niveau de métallisation formant une première électrode (2) de la capacité, et en ce que le condensateur comporte :
■ une première couche (5) barrière à diffusion de l'oxygène, déposée au-dessus du niveau de métallisation (2);
■ un empilement (6) de plusieurs couches d'oxydes différents, chaque couche présentant une épaisseur inférieure à 100 nanomètres, l'empilement étant déposé au-dessus de la première couche barrière (5) ;
■ une seconde couche (7) barrière à la diffusion de l'oxygène déposée au-dessus de l'empilement (6) des couches d'oxydes ;
■ une électrode métallique (20) présente au-dessus de la seconde couche barrière (7).

## Description

### Domaine technique

L'invention se rattache au domaine technique de la micro électronique. Elle vise plus précisément un composant électronique incorporant un micro condensateur pouvant être utilisé dans le cadre d'applications, radio-fréquences par exemple. Ce condensateur peut être réalisé sur la face supérieure du substrat du composant, ou bien encore à l'intérieur même du substrat, au coeur d'un circuit intégré. La conception d'un tel condensateur permet d'obtenir des valeurs de capacité particulièrement élevées.

### Techniques antérieures

La réalisation de micro-condensateurs sur des substrats de silicium a déjà fait l'objet de certains développements.

Ainsi, dans le document FR 2 801 425, on décrit un micro-condensateur dont la fraction diélectrique est composée de deux couches de matériaux différents, et plus précisément d'une part, du dioxyde de silicium, et d'autre part, du nitrure de silicium. De tels micro-condensateurs présentent l'inconvénient d'être limités dans les valeurs de capacité. En effet, les constantes diélectriques (εᵣ) des matériaux utilisés sont relativement faibles, typiquement de l'ordre de 4,1 pour le dioxyde de silicium et de 7 pour le nitrure de silicium. Ainsi, dans les applications nécessitant une capacité très élevée, il est nécessaire de réaliser des couches de faible épaisseur. La proximité des électrodes risquerait de se traduire alors par des phénomènes parasites non désirés, par effet tunnel. La tenue diélectrique de couches aussi peu épaisses doit également être citée parmi les inconvénients de telles capacités, comme provoquant des effets d'avalanche.

Par ailleurs, on a décrit dans la publication d'une demande de brevet américain US 2001/0041413, un procédé permettant de réaliser des circuits RC sur un substrat semi-conducteur de silicium. Plus précisément, la résistance et le condensateur sont obtenus à partir d'une même couche de tantale. Une partie de cette couche de tantale est utilisée pour former la résistance du circuit RC. Le condensateur est obtenu par oxydation d'une zone de la couche de tantale située à l'aplomb d'une des électrodes du condensateur. Plus précisément, cette oxydation est obtenue par diffusion d'oxygène sur cette zone spécifique. Après oxydation du tantale en oxyde de tantale, on obtient ainsi une couche diélectrique pouvant être recouverte par une seconde électrode pour former le condensateur. On constate néanmoins qu'une telle capacité présente un certain nombre d'inconvénients dus au procédé de fabrication. Ainsi, l'intégrité du matériau diélectrique est mal maîtrisée puisque le tantale est oxydé de façon prépondérante du côté de la face recevant le flux d'oxygène. Il s'ensuit une mauvaise homogénéité de la couche diélectrique qui peut être à la source de défectivités, et à tout le moins d'une grande variabilité dans les valeurs de capacité.

L'un des objectifs de l'invention est de permettre la réalisation de micro-condensateurs présentant de fortes valeurs de capacité.
Un autre objectif est d'obtenir ces fortes valeurs de capacité avec des couches d'une épaisseur supérieure à celles dans lesquelles il existe des risques d'apparition d'effets tunnel.
Un autre objectif de l'invention est de proposer un procédé de fabrication qui permette de maîtriser les valeurs de capacité, et de pouvoir les adapter selon les applications.
Un autre objectif de l'invention est de permettre la réalisation de ces micro-condensateurs sur des substrats incorporant un circuit intégré, pour lequel les températures maximales pendant les procédés de réalisation doivent être relativement limitées, et typiquement inférieures à 400°C.

### Exposé de l'invention

L'invention concerne donc un micro composant électronique incorporant un circuit intégré réalisé dans un substrat, et un condensateur planaire.

Conformément à l'invention, le condensateur est réalisé au-dessus d'un niveau de métallisation du composant, ce niveau de métallisation formant une première électrode du condensateur. En outre, le condensateur comporte :
■ une première couche barrière à diffusion de l'oxygène, déposée au-dessus du niveau de métallisation ;
■ un empilement de plusieurs couches d'oxydes différents, chaque couche présentant une épaisseur inférieure à 100 nanomètres, l'empilement étant déposé au-dessus de la première couche barrière ;
■ une seconde couche barrière à la diffusion de l'oxygène, déposée au-dessus de l'empilement des couches d'oxydes ;
■ une électrode métallique présente au-dessus de la seconde couche barrière.

Autrement dit, l'invention consiste à utiliser en tant que matériau diélectrique pour le condensateur une structure nanolaminée de différents oxydes, séparée des électrodes métalliques par une couche barrière à la diffusion de l'oxygène.

L'emploi des différentes couches d'oxydes permet d'obtenir des valeurs globales de permittivité relative permettant d'obtenir des capacités supérieures à 10 nF/mm². Ces différentes couches d'oxydes peuvent être obtenues par des méthodes de dépôt ne nécessitant obligatoirement pas d'opérations de recuit à haute température, ce qui les rend compatibles avec la réalisation de ces condensateurs en combinaison avec des circuits intégrés.

En pratique, le condensateur peut être réalisé soit au niveau supérieur du substrat. Dans ce cas, le niveau de métallisation correspond à un niveau supérieur du substrat, et par exemple à un plot d'interconnexion.

Le condensateur peut également être réalisé à l'intérieur du circuit intégré. Dans ce cas, le niveau de métallisation formant 1a première électrode correspond à un niveau de métallisation interne du circuit intégré.

Différents oxydes peuvent être utilisés pour former l'empilement de couches diélectriques. On pourra notamment citer les matériaux choisis parmi le groupe comprenant : HfO₂, Ta₂O₅, ZrO₂, La₂O₃ dans lequel La représente un lanthanide, Y₂O₃, Al₂O₃, TiO₂, MgO, CeO₂, Nb₂O₅, les titanates et tantalates de strontium (STO), les titanates de strontium et baryum (BST), les tantalates de strontium et bismuth (SBT), les titanates de plomb et zirconium (ZBT), les tantalates de baryum strontium (BST). Parmi ces matériaux, on pourra privilégier le pentaoxyde de Tantale Ta₂O₅ dont la permittivité relative est de l'ordre de 26, et le dioxyde de titane TiO₂ dont la permittivité relative est de l'ordre de 80. Ces matériaux peuvent être utilisés selon différentes combinaisons. Le nombre de couches de l'empilement ainsi que l'épaisseur de chacune de ces couches est déterminé en fonction des propriétés électriques, notamment la capacité que l'on souhaite obtenir.

En pratique, on préfèrera que les couches d'oxydes soient obtenues par dépôt de couches atomiques, technique également connue sous l'appellation ALD (Atomic Layer Deposition). En effet, grâce à cette technique, il est possible de maîtriser l'épaisseur de chacune des couches, ce qui permet de garantir une bonne homogénéité de cette épaisseur sur toute la surface de la couche diélectrique, et donc d'éviter les sources de défectivités. La technique de dépôt par ALD peut utiliser plusieurs sources de matériaux à savoir des sources solides, liquides ou gazeuses, ce qui rend cette technique très souple et évolutive. Par ailleurs, elle utilise des précurseurs qui sont les vecteurs de la réaction chimique de surface, et qui transportent la matière à déposer. Plus précisément, ce transport met en oeuvre un processus de chimie sorption des précurseurs sur la surface à recouvrir, en créant une réaction chimique avec échange de ligand entre les atomes en surface et les molécules des précurseurs. Le principe de cette technique évite l'adsorption des précurseurs ou leur condensation et donc leur décomposition. Des sites nucléiques sont continuellement créés jusqu'à la saturation de chaque phase de réaction, entre lesquelles une purge à l'aide de gaz inerte permet de renouveler le processus. La technique "ALD" se distingue de 1a technique répandue dans l'industrie des semiconducteurs utilisant la CVD (Chemical Vapor Deposition) en ce sens que les précurseurs utilisés en ALD sont très réactifs et ne se décomposent pas en surface. L'uniformité du dépôt est assurée par le mécanisme de réaction et non pas par les réactants utilisés comme c'est le cas en CVD, tandis que l'épaisseur des couches déposées par ALD dépend de chaque cycle de chimie sorption des précurseurs. Pour la technique ALD, il sera préférentiellement utilisé comme précurseurs des chlorites et oxychlorures telles que ZrCl₄ ou MoCl₅, des métallocènes tels que du ZrCp₂Cl₂, des métalacyls tels que Al(CH₃)₃, des béta dikétonates telles que du La(thd)₃, ou des alkoxides tels que du Ta-ethoxyde.

Avantageusement, en pratique, les matériaux utilisés pour former les couches barrière à diffusion de l'oxygène sont réalisés à partir de matériaux choisis dans le groupe comprenant : WSi₂, TiSi₂, CoSi₂, WN, TiN, TaN, NbN MoN, TaSiN, TiAlN, TaAlN. Ces matériaux sont déposés par la technique ALD.

Dans une forme préférée, le nitrure de titane (TiN) peut être préféré.

Le choix de ce matériau permet de limiter les éventuelles diffusions de l'oxygène des couches d'oxydes en direction des couches métalliques formant les électrodes.

Une telle structure de condensateur peut être utilisée selon différents modes de connexion. Ainsi, l'électrode inférieure peut être reliée au reste du circuit intégré par le niveau de métallisation. Ce même niveau de métallisation peut par exemple être relié à la masse.

Dans un autre mode de réalisation, le niveau de métallisation peut être rendu accessible par un plot de connexion qui lui est relié. Dans ce cas, les deux électrodes du condensateur sont accessibles, ce qui permet d'incorporer cette capacité en série dans un schéma électrique.

En pratique, l'électrode métallique ou l'éventuel plot de connexion supplémentaire peut être réalisé par dépôt électrolytique, par exemple de cuivre.

### Description sommaire des figures

La manière de réaliser l'invention et les avantages qui en découlent, ressortiront bien de la description du mode de réalisation qui suit, à l'appui des figures annexées dans lesquelles :

Les figures 1 à 13 sont des vues en coupe d'un exemple de composant réalisé conformément à l'invention, et montré à différents stades de réalisation.

La figure 14 est une vue en coupe d'une variante de réalisation.

Dans les figures, les dimensions et notamment les épaisseurs des différentes couches sont données à titre d'illustration pour permettre la compréhension de l'invention. Elles peuvent être sans rapport avec les dimensions réelles des différents éléments intervenant dans l'invention.

### Manière de réaliser l'invention

Comme déjà évoqué, l'invention concerne un micro-condensateur réalisé sur un composant électronique incorporant un circuit intégré.

Ce condensateur peut être réalisé, comme dans les figures illustrées, dans le niveau supérieur du substrat. Néanmoins, dans d'autres formes de réalisation non illustrées, ce micro-condensateur peut être réalisé au sein même du substrat, au niveau inférieur de métallisation du circuit intégré.

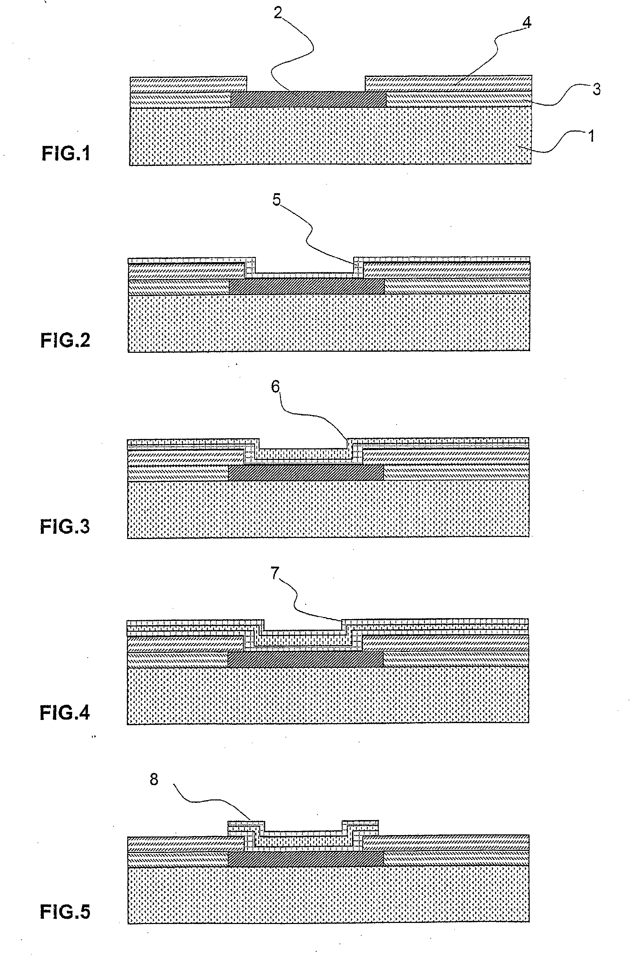

Ainsi, comme illustré à la figure 1, le substrat (1) peut comporter un plot de connexion (2) réalisé en un matériau tel que de l'aluminium ou du cuivre, voire un alliage d'aluminium et silicium, d'aluminium et cuivre ou de cuivre et zinc. Dans la forme illustrée, le substrat (1) est recouvert d'une première couche de passivation (3), typiquement en SiO₂. Cette couche de silice (3) est recouverte d'une couche de nitrure de silicium Si₃N₄ permettant de protéger la couche inférieure de silice contre l'exposition à l'air.

Avant de procéder aux dépôt des différentes couches caractéristiques, on procède à un nettoyage non corrosif, ce qui permet d'éliminer toutes les particules qui pourraient venir contaminer les étapes ultérieures du procédé.

Dans une première étape illustrée à la figure 2, on procède à un dépôt d'une couche de nitrure de titane (TiN). Cette couche (5) assure un effet de barrière à la diffusion de l'oxygène qui pourrait venir oxyder les couches inférieures. Cette couche de nitrure de titane (5) est déposée par ALD, ce qui lui confère une très bonne uniformité d'épaisseur et une excellente intégrité. Cette uniformité d'épaisseur permet d'assurer une épaisseur constante à la couche diélectrique qui sera déposée ultérieurement, afin de limiter les risques de défectivité, ou les diffusions par effet tunnel qui pourraient survenir en cas d'épaisseur trop faible de la couche diélectrique.

Le nitrure de titane peut être remplacé par un matériau présentant des propriétés analogues parmi les matériaux cités ci-avant. On recherchera notamment le fait que ce matériau présente une bonne affinité avec le matériau utilisé pour former l'électrode inférieure (2), possède une excellente adhésion sur les couches atomiques inférieures, et permet une bonne réaction de surface des précurseurs.

Par la suite, comme illustré à la figure 3, on procède aux dépôts successifs d'une pluralité de couches d'oxydes. Dans la forme illustrée, l'empilement de ces différentes couches d'oxydes (6) est illustré sous la forme d'une couche unique. Toutefois, cet empilement peut comporter un nombre important de couches élémentaires, pouvant aller jusqu'à plusieurs dizaines. Ces différentes couches d'oxydes présentent une épaisseur pouvant aller de 5 Å à quelques dizaines de nanomètres. Parmi les matériaux donnant les bons résultats, on a noté des empilements de couches d'alumine Al₂O₃ et de dioxyde de titane TiO₂. De bons résultats sont également obtenus avec des nanolaminés réalisés à partir de couches d'oxyde de tantale Ts₂O₅ et de dioxydes de titane TiO₂. Le dioxyde de titane, voire le dioxyde de zirconium, sont dans un état amorphe aux températures de l'ordre de 300 à 400°C, utilisées lors des étapes de dépôt par technique de dépôt par couche atomique ALD. A ces températures, les tantalates Ta₂O₅ se présentent sous phase instable, et l'association avec les couches de dioxyde de zirconium ou de titane, assure une certaine stabilité de phase du Ta₂O₅.

Par la suite, on procède, comme illustré à la figure 4, au dépôt d'une seconde couche de nitrure de titane TiN. Cette couche supplémentaire (7) peut être réalisée en utilisant les différents matériaux décrits ci-avant, dès lors qu'on obtient l'effet de barrière à l'oxygène, tout en conservant une bonne qualité d'accroche avec la couche métallique qui sera déposée ultérieurement.

Par la suite, on procède à différentes étapes de lithographie et de gravure permettant d'éliminer les différentes couches (5,6,7) déposées au-dessus du substrat. Ces étapes de gravure sont successives pour, dans un premier temps, éliminer la couche de nitrure de titane à l'exception de la zone (8) à l'aplomb du plot de connexion (2). Cette gravure peut par exemple s'effectuer avec du CCl₄ ou du CCl₂F₂ ou du CF₄ : H₂.Cette première étape de gravure est ensuite suivie d'une étape de gravure, par exemple à l'aide de fluorines telles que du SF₆, permettant d'éliminer la couche (6) d'oxyde nanolaminée. Après une dernière étape de gravure de la couche (5) de nitrure de titane, on obtient la structure illustrée à la figure 5.

Les étapes ultérieures permettent de définir l'électrode supérieure et le plot de connexion associé.

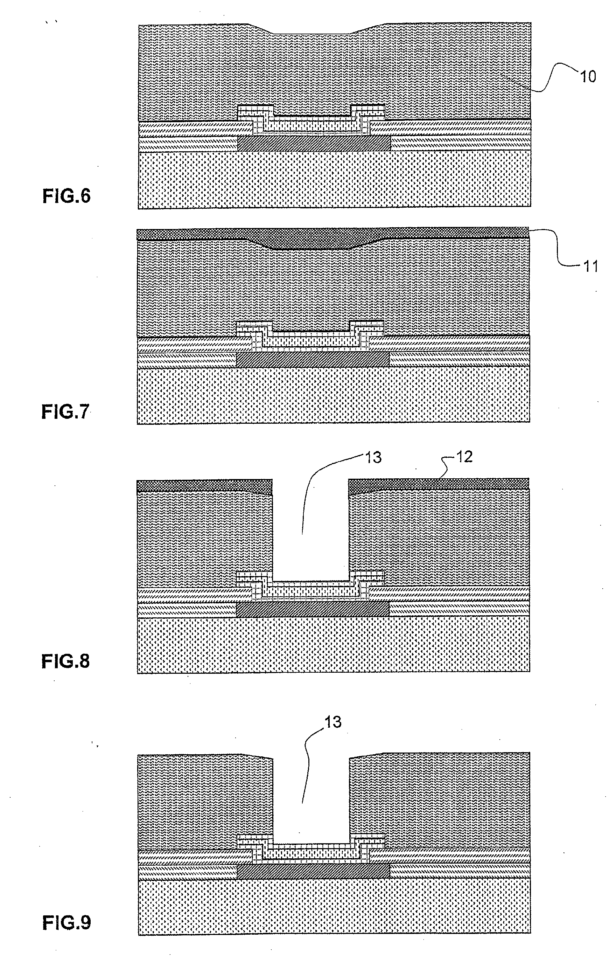

Ainsi, on procède par la suite, comme illustré à la figure 6, au dépôt d'une couche (10) de résine du type benzocyclobutène (BCB), par une technique de "*spin on deposition*". Cette couche de BCB présente typiquement une épaisseur supérieure à 500 nm.

On procède par la suite, comme illustré à la figure 7, au dépôt d'une couche (11) recouvrant la couche de BCB (10), en formant un masque dur. Les matériaux utilisé pour former ce masque dur (11) peuvent être relativement variés. Il peut notamment s'agir de carbure de silicium, mais encore de chrome, de siliciure de tungstène (WSi₂), ou bien encore de nitrure de titane ou de silice voire de nitrure de silicium. Préférentiellement il est utilisé du nitrure de silicium.

On procède par la suite à une étape de lithographie puis de gravure pour définir une ouverture de la couche de masque dur (11), à l'aplomb de l'électrode inférieure. Cette gravure peut par exemple être réalisée par voie humide en utilisant un bain à base d'acide hypophosphorique à température de 180°C. On peut également utiliser une gravure sèche par plasma en utilisant un gaz réactif de fluorine, tel que le CF₄:H₂ par exemple. On procède par la suite à une gravure anisotrope de la couche de BCB (10), à l'aplomb de l'électrode inférieure (2). Cette gravure de la couche de BCB (10) peut s'effectuer notamment par l'emploi d'un mélange de gaz tel que le mélange (Ar:CF₄:O₂), ou les mélanges (C₂H₂F₂:CO₂:H₂:Aᵣ) ou (SF₆:CO₂:Ar), ou bien encore par un plasma radiofréquence utilisant d'autres réactifs. On privilégiera dans le choix de cette technique de gravure la sélectivité par rapport à la couche inférieure (7) de nitrure de titane. Il importe en effet que cette couche ne soit pas trop fortement gravée lorsque la gravure du BCB est terminée. On obtient alors la configuration illustrée à la figure 8.

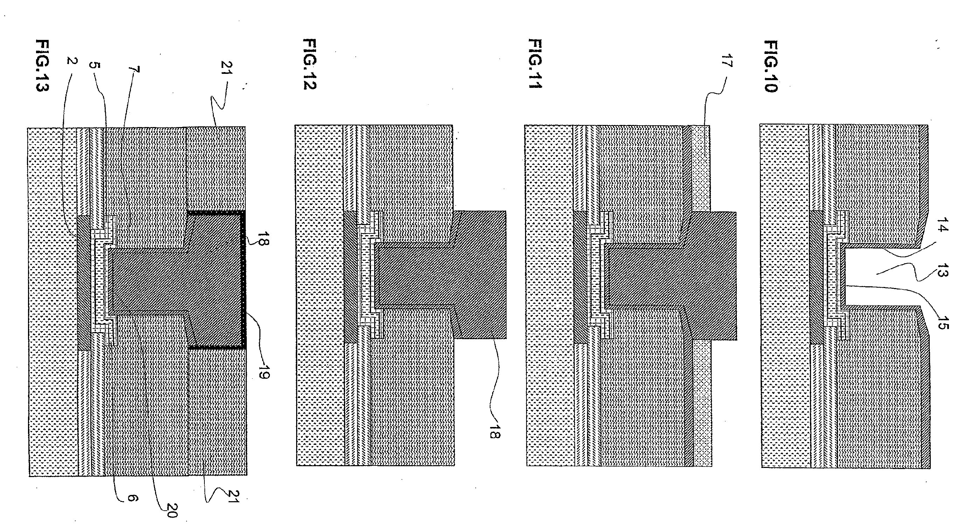

Par la suite, on procède, comme illustré à la figure 9, à l'élimination des parties latérales (12) du masque dur (11). Dans certains cas, cette élimination ne s'avère pas nécessaire notamment lorsque le matériau utilisé comme en masquinage est un isolant du type SiO₂. Dans d'autres cas au contraire, notamment le cas où le masque dur (11) est réalisé en chrome ou en siliciure de tungstène, il est préférable de procéder à l'élimination du reste du masque dur (11). Dans le cas particulier où le masque dur est réalisé en nitrure de titane, on procédera, préalablement à son élimination, au masquage de la couche (7) de nitrure de titane située à l'aplomb de l'électrode inférieure (2), afin que cette couche barrière de l'oxygène ne soit pas éliminée en même temps que le reste du masque dur.

Par la suite, on procède à une étape de nettoyage du trou (13) ainsi formé. Ce nettoyage peut s'effectuer par voie chimique, en mettant en oeuvre un mélange semi-aqueux non corrosif. Il peut également être obtenu par voie sèche, en utilisant un plasma.

Par la suite, comme illustré à la figure 10, on procède au dépôt d'une couche amorce de cuivre (16). Cette couche amorce (16) peut être déposée par différentes techniques, et notamment par pulvérisation, procédé également connu sous l'abréviation de PVD-IMP pour "Physical Vapour Deposition - Ionised Metal Plasma". On peut également utiliser la technique de dépôt chimique en phase de vapeur connue sous le nom de CVD pour "Chemical Vapor Deposition". On peut également utiliser une technique de dépôt atomique (ALD), similaire à celle utilisée pour le dépôt des différentes couches du nanolaminé (6).

On peut également procéder par la suite à une étape d'enrichissement de la couche amorce (16) de cuivre par voie électrolytique. Cet enrichissement permet de combler les espaces entre les îlots de cuivre qui ont été préalablement déposés pour former la couche amorce. La surface de cette couche amorce (16) est donc ainsi lissée, ce qui favorisera les étapes ultérieures de dépôt électrolytique du cuivre. Cette étape permet d'augmenter l'épaisseur de la couche amorce à l'intérieur de la via (13), et particulièrement sur les faces internes (14) et au fond (15) du trou (13).

Par la suite, on procède, comme illustré dans la figure 11, au dépôt d'une couche de résine (17) qui est ensuite éliminée dans la zone du micro-condensateur. Plus précisément, cette couche de résine est éliminée dans la via (13) et dans la périphérie de cette dernière, pour ne demeurer que dans les zones (17) illustrées à la figure 11. Par la suite, on procède à un dépôt électrolytique de cuivre, selon une technique dite de "croissance par le bas", correspondant à une technique particulière lorsque la structure est une damascène. Cette technique est également connue sous l'appellation de "bottom-up damascene superfilling".

Cette étape permet de remplir le volume de la via (14), et de recouvrir les faces supérieures du composant, à l'exception des zones où la couche amorce (16) est recouverte par la couche de résine (17).

D'éventuelles étapes de recuit peuvent ensuite être mises en oeuvre.

Par la suite, on procède comme illustré à la figure 12, à l'élimination de la résine (17) qui a permis de définir la forme du plot de connexion (18) à l'électrode supérieure (20). La couche amorce de cuivre (16) est également éliminée par une opération de gravure, qui peut être une gravure humide anisotrope, par exemple à base d'un bain d'acide sulfurique ou d'un bain d'acide nitrique incluant du benzotriazole ou tout autre dérivé d'imidazole.

On peut ensuite procéder à une étape de nettoyage non corrosif, permettant d'éliminer tous les résidus de la résine utilisés lors des différentes étapes de procédé. Ce nettoyage permet également d'éliminer toutes les particules susceptibles de corroder le cuivre.

Pour certaines applications, il peut notamment être utile de déposer, comme illustré à la figure 13, une couche d'accroche au dessus du plot de connexion (18) de cuivre. Cette couche d'accroche (19) peut par exemple être à base de nickel ou de cobalt. On procède par la suite au dépôt d'une couche de polyimide (21), jusqu'à une hauteur correspondant à la hauteur du plot (18). Cette couche de passivation (21) peut être déposée par "spin-on deposition".

Le polyimide peut également être remplacé par un autre matériau du type Parylène®. Cette couche de passivation peut alors être déposée par PECVD. Il n'est alors pas nécessaire de recouvrir le plot de cuivre (18) d'une couche (19) de nickel ou de cobalt.

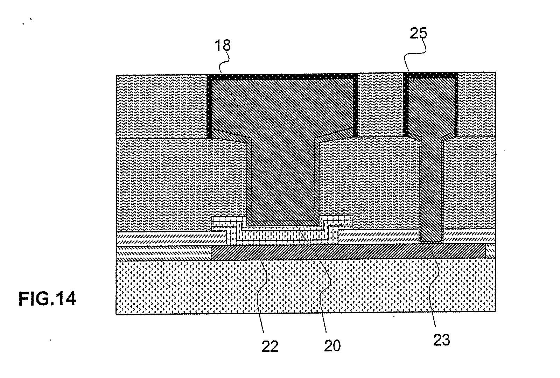

Dans une variante illustrée à la figure 14, le niveau de métallisation (22) formant l'électrode inférieure peut se prolonger latéralement. La zone (23) décalée par rapport au condensateur peut alors accueillir un plot de connexion (25) réalisé selon une technique analogue à celle décrite pour la réalisation du plot (18). Le condensateur formé entre l'électrode supérieure (20) et le niveau de métallisation (22) est alors accessible depuis la face supérieure du substrat, entre deux plots de connexion (25,18).

A titre d'exemple, on a réalisé différents micro-condensateurs conformément à l'invention.

Ainsi, dans un premier exemple particulier, l'empilement de couches d'oxydes comporte cinq couches de dioxyde de zirconium ZrO₂, séparées chacune par une couche d'oxyde de tantale Ta₂O₅. Chaque couche possède une épaisseur de l'ordre de 10Å. La capacité ainsi obtenue est de l'ordre de 28 nF/mm².

Dans un deuxième exemple, on a réalisé un empilement de neuf couches d'oxydes, à savoir cinq couches de dioxyde de titane TiO₂, séparées chacune par une couche d'oxyde de tantale Ta₂O₅. Cet empilement possède une capacité de 38 nF/mm².

Il ressort de ce qui précède que les micro-condensateurs conformes à l'invention présentent de multiples avantages, notamment en premier lieu, une valeur de capacité nettement supérieure à celle des solutions existantes. Ces hautes valeurs de capacité sont obtenues en conservant des épaisseurs de couches diélectriques qui ne sont pas susceptibles de laisser apparaître des phénomènes par effet Tunnel et effet d'avalanche.

## Revendications

1. Composant électronique incorporant un circuit intégré réalisé dans un substrat (1) et un condensateur planaire, **caractérisé en ce que** le condensateur est réalisé au-dessus d'un niveau de métallisation du composant, ce niveau de métallisation formant une première électrode (2) du condensateur, et **en ce que** le condensateur comporte :
■ une première couche (5) barrière à diffusion de l'oxygène, déposée au-dessus du niveau de métallisation (2);
■ un empilement (6) de plusieurs couches d'oxydes différents, chaque couche présentant une épaisseur inférieure à 100 nanomètres, l'empilement étant déposé au-dessus de la première couche barrière (5);
■ une seconde couche (7) barrière à la diffusion de l'oxygène déposée au-dessus de l'empilement des couches d'oxydes (6) ;
■ une électrode métallique (20) présente au-dessus de la seconde couche barrière (7).

2. Composant électronique selon la revendication 1, **caractérisé en ce que** le niveau de métallisation (2) se situe au niveau supérieur du substrat.

3. Composant électronique selon la revendication 1, **caractérisé en ce que** le niveau de métallisation correspond à un niveau de métallisation interne du circuit intégré.

4. Composant électronique selon la revendication 1, **caractérisé en ce que** les matériaux utilisés pour réaliser les couches d'oxydes (6) sont choisis parmi le groupe comprenant : HfO₂, Ta₂O₅, ZrO₂, La₂O₃ dans lequel La représente un lanthanide, Y₂O₃, Al₂O₃, TiO₂, MgO, CeO₂, Nb₂O₅, les titanates et tantalates de strontium (STO), les titanates de strontium et baryum (BST), les tantalates de strontium et bismuth (SBT), les titanates de plomb et zirconium (ZBT), les titanates de baryum et strontium (EST).

5. Composant électronique selon la revendication 1, **caractérisé en ce que** les couches d'oxydes (6) sont obtenues par dépôt de couches atomiques

6. Composant électronique selon la revendication 1, **caractérisé en ce que** les couches (5,7) barrière à la diffusion de l'oxygène sont réalisées à partir de matériaux choisis dans le groupe comprenant : WSi₂, TiSi₂, CoSi₂, WN, TiN, TaN, NbN, MoN, TaSiN, TiAlN, TaAlN.

7. Composant électronique selon la revendication 1, **caractérisé en ce qu'**il comporte également un plot de connexion (25) relié à la première électrode (22), permettant ainsi l'accès aux deux électrodes du condensateur.

8. Procédé de fabrication d'un condensateur réalisé sur le substrat d'un composant électronique incorporant un circuit intégré, **caractérisé en ce qu'**il comporte les étapes suivantes consistant, au-dessus d'un niveau de métallisation (2) du composant destiné à former une première électrode du condensateur, à :
◆ déposer une première couche (5) barrière à la diffusion de l'oxygène ;
◆ déposer une succession (6) de couches d'oxydes différents, chaque couche présentant une épaisseur inférieure à 100 nanomètres ;
◆ déposer une seconde couche (7) barrière à la diffusion de l'oxygène,
◆ déposer une électrode métallique (20).

9. Procédé selon la revendication 8, **caractérisé en ce que** la seconde électrode métallique (20) est réalisée par dépôt électrolytique.

10. Procédé selon la revendication 8, **caractérisé en ce que** les couches d'oxyde (6) sont déposées par dépôt de couches atomiques.

11. Procédé selon la revendication 10, **caractérisé en ce que** dépôt de couches atomiques est réalisé en utilisant des précurseurs choisis dans le groupe comprenant: les chlorites, les oxychlorures, les métallocènes, les métalacyls, les béta-dilcétonates et les alkoxydes.
